# FASCICULE DE BREVET EUROPEEN

(11) **EP 2 584 575 B1**
(45) Date de publication et mention de la délivrance du brevet: **21.12.2016**
(21) Numéro de dépôt: 12306115.2
(22) Date de dépôt: 17.09.2012
(51) Int. Cl.: H01H 1/00, H01H 47/00, H01H 51/00

(54) **Procédé de diagnostic d'un état de fonctionnement d'un contacteur et contacteur pour la mise en oeuvre dudit procédé.**
Verfahren zur Diagnose eines Betriebszustands für einen Schütz und Schütz zur Implementierung dieses Verfahrens
Method for diagnosing an operating state of a contactor and contactor for implementing said method

(30) Priorité: 21.10.2011 FR 1103225
(43) Date de publication de la demande: 24.04.2013
(73) Titulaire: Schneider Electric Industries SAS, 92500 Rueil-Malmaison (FR)
(72) Inventeur: Delbaere, Stéphane, 38050 Grenoble Cedex 9 (FR); Orban, Rémy, 38050 Grenoble Cedex 9 (FR)
(74) Mandataire: Tripodi, Paul

(56) Documents cités:
- EP-A1- 1 555 683
- WO-A1-2006/069957
- WO-A1-2007/033913
- DE-A1-102010 003 485
- DE-C1- 19 734 224
- FR-A1- 2 834 120

## Description

### DOMAINE TECHNIQUE DE L'INVENTION

L'invention est relative à un procédé de diagnostic d'un état de fonctionnement d'un contacteur comprenant une unité de traitement destinée à agir sur des moyens de commande de la tension. Le contacteur comprends en outre au moins une bobine d'actionnement, des moyens de mesure d'au moins une caractéristique électrique de ladite au moins une bobine d'actionnement et au moins une diode de roue libre connectée en parallèle de ladite au moins une bobine d'actionnement, et des moyens de mesure.

L'invention est aussi relative à un contacteur pour la mise en oeuvre dudit procédé. Ledit contacteur comporte un actionneur électromagnétique ayant circuit magnétique formé d'une culasse magnétique et d'un noyau ferromagnétique mobile, des moyens de commande, au moins une bobine d'actionnement reliée à une première et seconde borne d'alimentation à travers lesdits moyens de commande. Une unité de traitement est destinée à agir sur les moyens de commande de la tension. Le contacteur comporte aussi des moyens de mesure d'une caractéristique électrique de ladite bobine d'actionnement. Au moins une diode de roue libre est connectée en parallèle de ladite au moins une bobine d'actionnement et les moyens de mesure.

### ETAT DE LA TECHNIQUE ANTERIEURE

Les méthodes de diagnostic d'un état d'usure d'un contacteur sont appelées à être implémentées de plus en plus souvent dans les moyens de traitement des contacteurs. Il est en effet très utile de connaitre le niveau d'usure d'un contacteur afin de prévoir une maintenance adaptée au cours de la vie dudit contacteur.

Certains brevets existant décrivent ainsi des méthodes de diagnostic d'usure. Cependant l'implémentation de ces méthodes entraine généralement des couts supplémentaires souvent rédhibitoires pour une utilisation industrielle des produits.

Le brevet référencé US6225807 décrit une méthode pour évaluer la durée de vie résiduelle d'un contacteur. La méthode consiste à détermination de l'usure des pastilles de contacts, grâce à la détermination de la diminution de l'effet des ressorts de pôles sur la phase d'ouverture des contacts. Cette diminution de l'effet des ressorts, est corrélée à la diminution du temps écoulé entre deux instants précis que sont :
- L'instant de début du mouvement de la partie mobile en phase d'ouverture ;
- L'instant d'ouverture des contacts puissance.

Le premier instant est déterminé grâce à l'identification d'une surtension bobine générée à la coupure de la tension de commande. Le deuxième instant est déterminé grâce à la tension qui apparaît aux bornes des contacts, lorsqu'ils sont ouverts.

Cette méthode présente l'inconvénient de nécessiter de faire l'acquisition des tensions au niveau des pôles, et de la surtension à l'ouverture. Ces acquisitions impliquent la mise en oeuvre de moyens supplémentaires pouvant être couteux.

D'autres brevets (FR2834120) décrivent une méthode de diagnostic de fin de vie reposant sur l'évaluation de l'évolution des écrasements de contacts, réalisés à partir d'une mesure de tension bobine et de l'état d'un contact auxiliaire. Cette méthode ne permet pas de diagnostiquer une fin de vie liée à une défaillance mécanique liée à des frottements par exemple. Par ailleurs, cette méthode présente l'inconvénient de nécessiter des capteurs dédiés pour l'acquisition des courants de puissance.

Enfin, les méthodes de diagnostic connues sont incomplètes car ne prennent généralement pas en compte deux phénomènes indépendants de l'écrasement de contact mais pouvant accélérer la fin de vie du contacteur. Ces phénomènes sont la fréquence et l'intensité des collages de pastilles d'une part, et les défaillances mécaniques d'autre part. La fréquence et l'intensité des collages des pastilles sont communément appelés micro-soudages. On entend par défaillance mécanique, les disfonctionnements du contacteur liés aux frottements, aux usures, à la déformation des mécanismes mobiles, etc.

### EXPOSE DE L'INVENTION

L'invention vise donc à remédier aux inconvénients de l'état de la technique, de manière à proposer un procédé de diagnostic de fonctionnement, notamment d'usure de contacteur, ne nécessitant ni de capteur de courant, ni de capteur de tension au niveau des contacts de puissance.

Le procédé selon l'invention consiste à :
- envoyer un ordre de retombée consistant à fixer une tension dite de retombée aux bornes de la bobine d'actionnement ;
- mesurer pendant un temps de retombée, une caractéristique électrique de ladite bobine d'actionnement ;
- reconstituer à partir des mesures au moins une valeur spécifique;
- comparer ladite au moins une valeur spécifique à un gabarit de fonctionnement initial spécifique du contacteur ;
- diagnostiquer l'état d'usure du contacteur en fonction du positionnement ladite au moins une valeur spécifique par rapport au gabarit.

Selon un mode de développement de l'invention, la tension de retombée est fixée par la diode de roue libre, la bobine d'actionnement étant en mode « roue libre » pendant une partie du temps de retombée.

Avantageusement, la bobine d'actionnement est en mode « roue libre » pendant tout le temps de retombée.

Selon un autre mode de développement de l'invention, des moyens de shuntage commandent une diode zener pour fixer la tension de retombée aux bornes de la bobine d'actionnement, ladite bobine étant en mode « zener» pendant une partie du temps de retombée.

De préférence, la bobine d'actionnement est en mode « zener » pendant un temps intermédiaire de retombée, le temps intermédiaire de retombée étant inférieur au temps total de retombée.

Selon un premier mode de réalisation du procédé selon l'invention, ladite caractéristique électrique de ladite bobine d'actionnement mesurée pendant un temps total de retombée, est le courant électrique circulant dans la bobine d'actionnement.

De préférence, le procédé de diagnostic consiste à
- déterminer au moins une valeur spécifique sur une courbe d'évolution du courant électrique correspondant à un temps pour atteindre un premier maximum local sur la courbe d'évolution ;
- diagnostiquer l'état de fonctionnement du contacteur en fonction du positionnement du premier maximum local par rapport à un gabarit.

Avantageusement, le procédé consiste à déterminer un courant maximum atteint au niveau du premier maximum local (B) sur la courbe d'évolution (Si) du courant.

Selon un second mode de réalisation du procédé selon l'invention, ladite caractéristique électrique de ladite bobine d'actionnement mesurée pendant un temps de retombée, est la tension électrique aux bornes la bobine d'actionnement. De préférence, le procédé de diagnostic consiste à :
- déterminer au moins une valeur spécifique sur une courbe d'évolution de la tension électrique correspondant à un temps pour atteindre un premier minimum local sur la courbe d'évolution,
- diagnostiquer l'état de fonctionnement du contacteur en fonction du positionnement du premier minimum local par rapport à un gabarit.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :

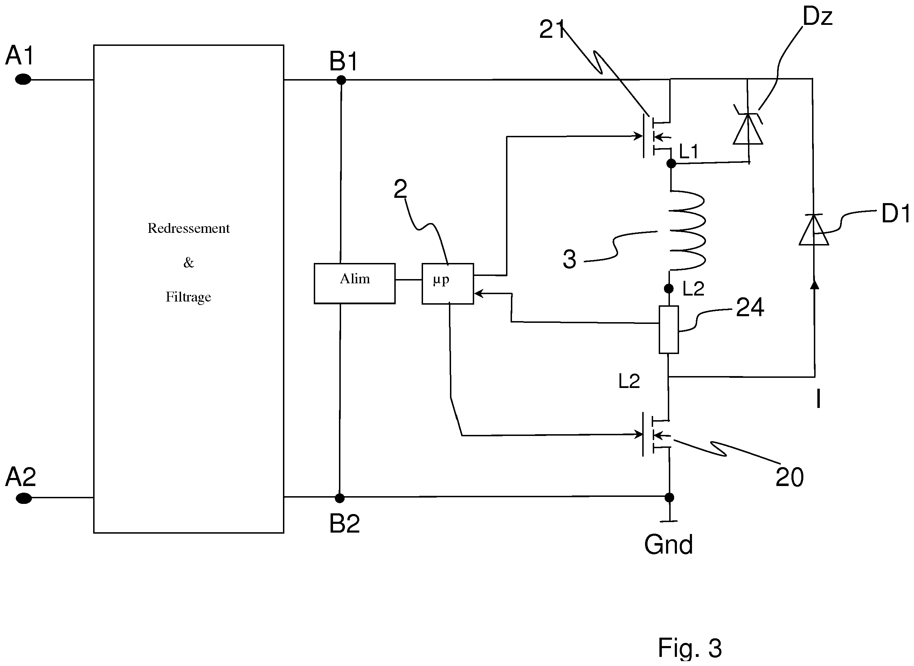

Les figures 1 à 3 représentent des schémas électriques fonctionnels de circuits de commande et de régulation adaptés pour la mise en oeuvre d'un procédé de diagnostic selon les différents modes de réalisation de l'invention ;
La figure 4A représente une courbe d'évolution d'un courant de retombée mesuré au cours du procédé de diagnostic d'usure selon le premier mode de réalisation de l'invention utilisant un circuit de commande selon la figure 1 ;
La figure 4B représente une courbe d'évolution d'un courant de retombée mesuré au cours du procédé de diagnostic d'usure selon le premier mode de réalisation de l'invention utilisant un circuit de commande selon la figure 2 ;
La figure 5 représente des gabarits correspondant respectivement à des courbes d'évolution théoriques d'un courant de retombée pour un contacteur neuf et pour un contacteur usé ;
la figure 6 représente des courbes d'évolution de courants mesurés au cours du procédé de diagnostic d'usure d'un contacteur dans différents états de fonctionnement ;
la figure 7 représente des courbes d'évolution de courants mesurés au cours du procédé de diagnostic d'usure d'une variante de contacteur dans différents états de fonctionnement ;
la figure 8 représente un schéma de principe d'actionneur de contacteur selon un mode de réalisation de l'invention ;
la figure 9 représente un schéma de principe d'actionneur de contacteur selon un autre mode de réalisation de l'invention ;
la figure 10 représente des courbes d'évolution de la tension mesurée au cours du procédé de diagnostic d'usure selon un second mode de réalisation de l'invention utilisant un circuit de commande selon la figure 1 ;
la figure 11 représente des courbes d'évolution de la tension mesurée au cours du procédé de diagnostic d'usure le second mode de réalisation de l'invention utilisant un circuit de commande selon la figure 2.

### DESCRIPTION DETAILLEE D'UN MODE DE REALISATION

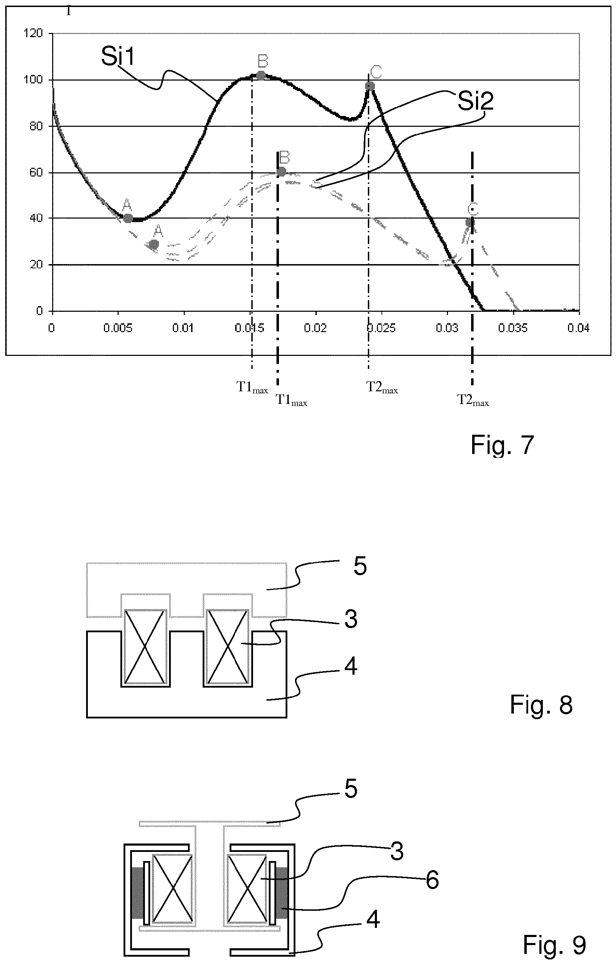

Le procédé de diagnostic d'un état de fonctionnement d'un contacteur selon l'invention est particulièrement destiné à un contacteur ayant un actionneur électromagnétique comprenant un circuit magnétique formé d'une culasse magnétique 4 et d'une partie mobile 5 ferromagnétique (figure 8). Le déplacement de la partie mobile est commandé par au moins une bobine d'actionnement 3 reliée à une première et seconde bornes d'alimentation B1, B2 à travers des moyens de commande 20 de la tension bobine. Une unité de traitement 2 est destinée à agir sur les moyens de commande 20 de la tension bobine, tels notamment des transistors de type MOS ou de type IGBT.

Le procédé de diagnostic d'un état de fonctionnement du contacteur comporte trois étapes successives.

La première étape consiste, suite à la détection d'un ordre d'ouverture du contacteur, à commander la bobine d'actionnement 3, de sorte, d'une part à évacuer l'énergie électrique stockée dans celle-ci pour diminuer l'effort magnétique et permettre le mouvement de la partie mobile 5 de l'actionneur, et d'autre part, à générer un signal représentatif du mouvement de la partie mobile 5 de l'actionneur. Ledit signal est proportionnel à une caractéristique électrique K de la bobine. Les moyens de commande 20 envoient un ordre de retombée consistant à fixer une tension dite de retombée aux bornes L1, L2 de la bobine d'actionnement 3.

La deuxième étape consiste à réaliser l'acquisition des valeurs spécifiques sur ce signal pendant une phase de retombée. Ces valeurs spécifiques sont corrélées à la vitesse de mouvement de la partie mobile 5.
Selon un premier mode de réalisation de l'invention, la caractéristique électrique K de ladite bobine d'actionnement 3 mesurée pendant un temps total de retombée Ta, est le courant électrique I circulant dans la bobine d'actionnement 3. La deuxième étape du procédé de diagnostic consiste alors à déterminer les valeurs spécifiques sur le signal de courant électrique I circulant dans la bobine d'actionnement 3.
Selon un second mode de réalisation de l'invention, la caractéristique électrique K de ladite bobine d'actionnement 3 mesurée pendant un temps total de retombée Ta, est la tension électrique U aux bornes de la bobine d'actionnement. La deuxième étape du procédé de diagnostic consiste alors à déterminer les valeurs spécifiques sur le signal de tension aux bornes de bobine d'actionnement 3, comme, par exemple, une valeur de tension à un temps défini.

La troisième étape consiste en un traitement de ces valeurs spécifiques, permettant de déterminer l'état de fonctionnement du contacteur, notamment son niveau d'usure.

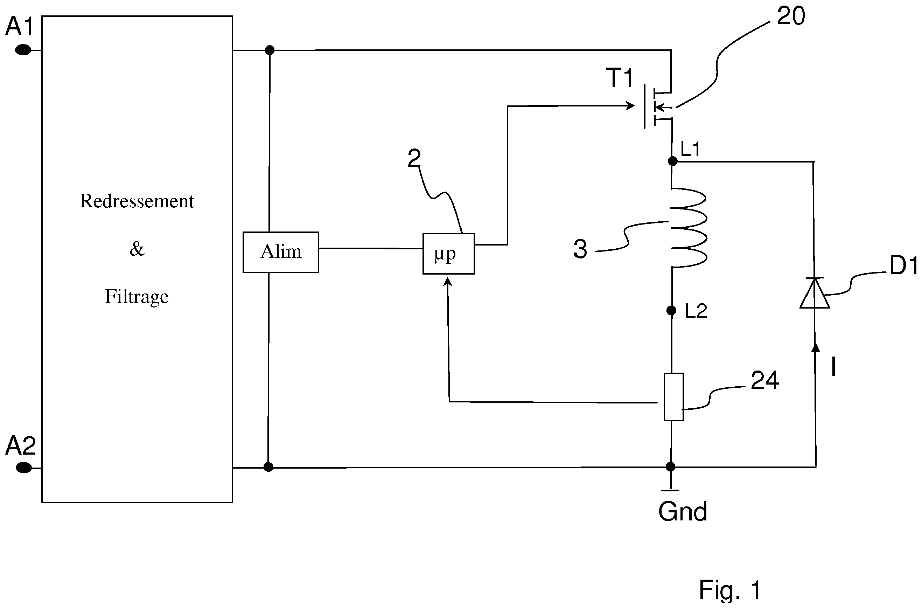

Selon un premier mode de réalisation de l'invention, la caractéristique électrique K mesurée au cours du procédé étant le courant électrique circulant dans la bobine de commande, le contacteur comporte alors des moyens de mesure 24 du courant électrique I, circulant dans la bobine d'actionnement 3 (figure1). Lesdits moyens peuvent comporter un shunt résistif placé en série avec la bobine d'actionnement 3. Enfin, une diode de roue libre D1 est connectée en parallèle de l'ensemble constitué de ladite au moins bobine d'actionnement 3, du moyen de mesure 24 du courant électrique I.

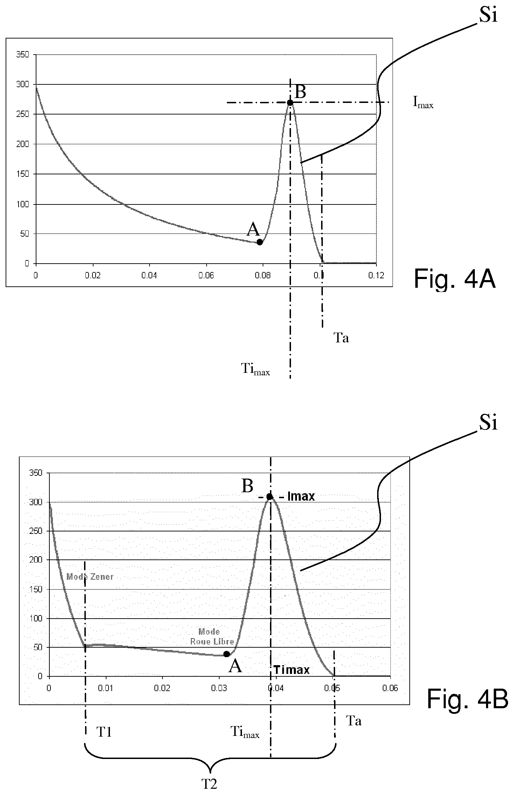

Dans la première étape du procédé de diagnostic selon ce premier mode de réalisation, les moyens de commande 20 envoient un ordre de retombée consistant à fixer une tension dite de retombée aux bornes L1, L2 de la bobine d'actionnement 3. Tel que représenté sur la figure 4A, la tension de retombée est fixée par la diode de roue libre D1. La bobine est alors en mode « roue-libre » pendant une durée de retombée Ta. Le courant électrique qui est généré dans la bobine est représentatif de la vitesse de mouvement de la partie mobile 5 de l'actionneur.

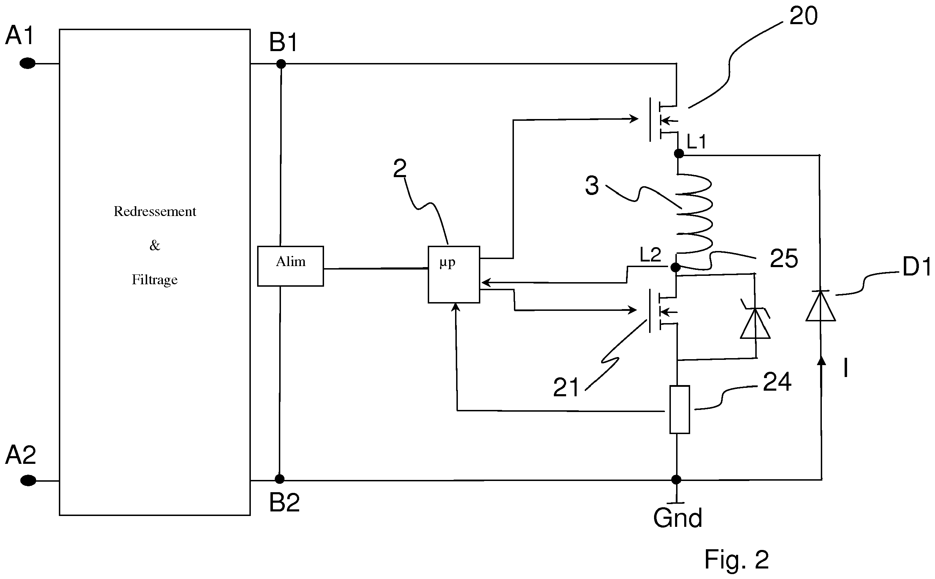

Selon une variante de réalisation, une diode Zener Dz peut avantageusement être connectée en série avec la bobine d'actionnement 3. Selon la figure 2, la diode Zener Dz est insérée de préférence en série avec la bobine d'actionnement 3 et les moyens de mesure 24 du courant électrique I. Des moyens de shuntage 21 connectés en parallèle de ladite diode sont aptes à shunter ladite diode Zener lorsque que ces derniers sont dans une position fermée. Dans la première étape du procédé de diagnostic tel que représenté sur la figure 4B, les moyens de commande 20 envoient un ordre de retombée fixant une tension dite de retombée aux bornes L1, L2 de la bobine d'actionnement 3. Les moyens de « shuntage » 21 sont dans une position ouverte et la tension de retombée est fixée par la diode « zener » Dz. La bobine est alors en mode « zener ». La tension de retombée fixée par la diode « zener » Dz peut être appliquée pendant toute la durée du temps total de retombée Ta ou pendant une partie seulement de la durée de retombée. Par exemple, comme représenté sur la figure 4B, les moyens de commande 20 placent la bobine d'actionnement 3 en mode « zener» pendant un temps intermédiaire de retombée T1, puis placent alors ladite bobine en mode « roue-libre », pendant une durée de mesure T2. Ainsi, le fait de placer la bobine en mode « zener » pendant tout ou partie de la durée de retombée permet de réduire le temps d'ouverture du contacteur. Le fait de placer la bobine en mode « zener » pendant tout le temps de retombée Ta réduit au maximum le temps d'ouverture du contacteur.

Selon une variante de réalisation non représentée, les moyens de commande 20 placent la bobine d'actionnement 3 en mode « roue-libre » pendant un temps intermédiaire de retombée, puis placent alors ladite bobine en mode « zener».

La deuxième étape du procédé de diagnostic selon ce premier mode de réalisation consiste à déterminer une ou plusieurs valeurs spécifiques sur la courbe d'évolution Si du courant électrique I de retombée circulant dans la bobine d'actionnement 3.

La ou les valeurs spécifiques peuvent, par exemple, être déterminées à partir :
- D'une ou plusieurs valeurs de courant mesurées à un temps défini, ou
- De l'intégration de valeurs de courant mesurées sur une plage temporelle définie, ou
- D'une ou plusieurs valeurs d'extremum local, extremum pouvant être un maximum ou un minimum, ou

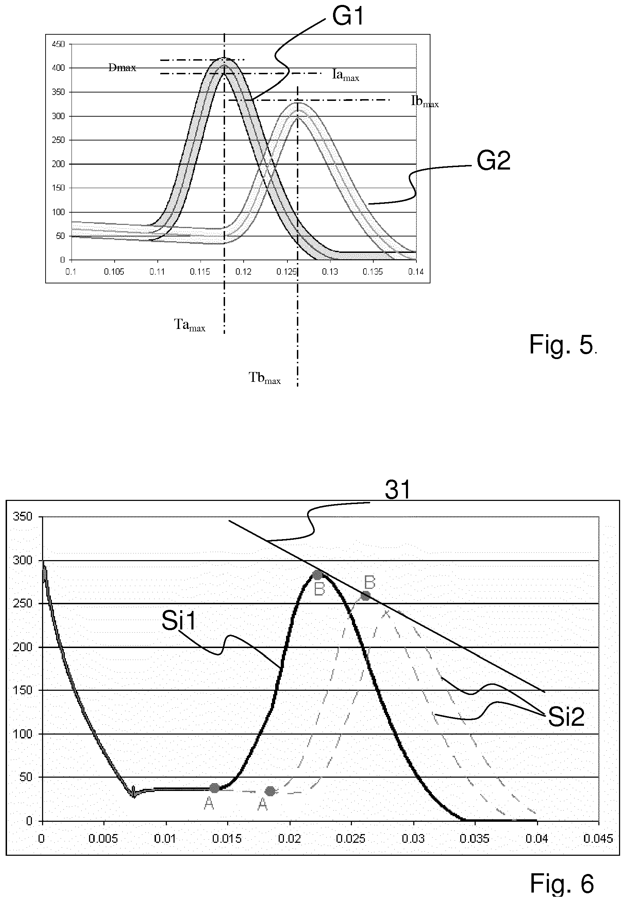

Comme observé sur les figures 4A, 4B, plusieurs points extremums locaux A, B peuvent être observés sur les courbes d'évolution Si du courant. Notamment, un premier maximum local B fixe un courant maximum Imax atteint par le courant bobine, dans la phase de mouvement de la partie mobile 5 de l'actionneur. Ce premier maximum local B permet aussi de définir le temps maximum Timax séparant la commande envoyée par les moyens de commande 20 et l'apparition dudit courant maximum Imax. Un premier minimum local A correspond sensiblement au début du mouvement du noyau 5 de l'actionneur. Tel que représenté sur la figure 6, une première courbe Si1 en trait plein correspond à la courbe d'évolution d'un actionneur neuf. Des seconds courbes Si2 en trait pointillé correspondent aux courbes d'évolution d'actionneurs usés.

Dans un mode particulier de réalisation d'actionneur, intégrant au moins un aimant, tel que représenté à la figure 9, une second maximum local C peut être observé sur la courbe d'évolution Si du courant (figure 7). Les premier et second maximums locaux B, C fixent des courants maximum Imax1, Imax2 atteint par le courant bobine, dans la phase de mouvement de la partie mobile 5 de l'actionneur. Lesdits maximums locaux B, C permettent aussi de définir des temps maximum Timax1 Timax2 séparant la commande envoyée par les moyens de commande 20 et l'apparition desdits courant maximum Imax1 et Imax2. Ces valeurs spécifiques sont alors représentatives de la vitesse de mouvement de l'actionneur. Tel que représenté sur la figure 7, une première courbe Si1 en trait plein correspond à la courbe d'évolution d'un contacteur neuf. Des seconds courbes Si2 en trait pointillé correspondent aux courbes d'évolution de contacteurs usés.

De manière avantageuse, les valeurs spécifiques de courant maximum relevées, peuvent être compensées en température, pour éviter tout biais de mesure lié à ce paramètre extérieur, et permettant de rendre l'exploitation de ces valeurs spécifiques plus précise.

La troisième étape du procédé de diagnostic selon ce premier mode de réalisation, consiste en une exploitation des valeurs spécifiques et permettre ainsi la détermination de l'état de fonctionnement.

Des gabarits mini et maxi sont de préférence définis pour chaque contacteur, prenant en compte ses dispersions industrielles. Ces gabarits permettent de déterminer, pour chaque valeur spécifique, d'une part un seuil état neuf, en utilisant la limite du gabarit neuf issue du tolérancement, et d'autre part un seuil état usé, en utilisant la limite du gabarit usé issue du tolérancement. A titre d'exemple de réalisation, tel que représenté à la figure 5, un premier gabarit G1 représentant une courbe d'évolution du courant électrique pendant une phase de retombée d'un contacteur neuf, permet de déterminer les valeurs seuil à l'état neuf lamax et Tamax. Un second gabarit G2 représentant une courbe d'évolution du courant électrique pendant une phase de retombée d'un contacteur usé permet de déterminer les valeurs seuil à l'état usé Ibmax et Tbmax. De préférence, des dispersions maxi sont définies pour chaque valeur spécifique, grâce aux gabarits de chaque contacteur, prenant en compte ses dispersions industrielles. Ces gabarits permettent alors de déterminer, pour chaque valeur spécifique, une dispersion maxi correspondant aux variations naturelles des différents constituants du contacteur. A titre d'exemple de réalisation, tel que représenté à la figure 5, sur le gabarit G1 représentant une courbe d'évolution du courant électrique pendant une phase de retombée d'un contacteur neuf, permet de déterminer la dispersion Dmax de la valeur spécifique Imax.

Par ailleurs, de manière à rendre l'exploitation des valeurs spécifiques moins sensibles aux paramètres pouvant perturber la mesure, on peut avantageusement réaliser une moyenne glissante des valeurs spécifiques enregistrées sur un nombre défini de manoeuvres consécutives précédentes. Ainsi, chaque valeur spécifique enregistrée et moyennée sur un nombre défini de manoeuvres consécutives précédentes, est ensuite comparée aux valeurs seuil définies grâce aux gabarits. La position de la valeur spécifique relativement aux valeurs seuil neuf et usé, donnent l'information de l'état de fonctionnement. Ensuite, pour chaque valeur spécifique enregistrée sur un nombre défini de manoeuvres consécutives précédentes, on peut calculer son étendue glissante, correspondant à la différence entre la valeur maximale et la valeur minimale enregistrées sur les manoeuvres précédentes. Un état de fonctionnement anormal est diagnostiqué, lorsque l'étendue glissante est supérieure à la dispersion maximale définie par les gabarits, pour chaque valeur spécifique.

Selon un deuxième mode de réalisation de l'invention, la caractéristique électrique K mesurée au cours du procédé étant la tension U aux bornes de la bobine, le contacteur comporte alors des moyens de mesure 25 de la tension bobine d'actionnement 3, pendant la phase d'ouverture du contacteur (figure 2).

Une diode Zener Dz, de valeur suffisamment élevée pour ne pas limiter l'évolution de la tension, est insérée en série avec la bobine d'actionnement 3, ladite diode Zener pouvant être shuntée par des moyens de shuntage 21. Les moyens de « shuntage » 21 sont dans une position ouverte et la tension de retombée est fixée par la diode « zener » Dz. La bobine est alors en mode « zener ». Enfin, une diode de roue libre D1 est connectée en parallèle de l'ensemble constitué de ladite au moins bobine d'actionnement 3 et de la diode Zener Dz, elle-même en parallèle des moyens de shuntage 21. De manière avantageuse, tel que représenté à la figure 2, les moyens de mesure 25 de la tension bobine peuvent être réalisés par une mesure du potentiel à une première borne de la bobine L2, lequel potentiel pouvant être ramené à l'unité de traitement 2, via un pont diviseur résistif pour être adapté à la plage de tension d'entrée de l'unité de traitement 2. Dans la phase d'ouverture du contacteur et dans ce schéma de réalisation, le potentiel mesuré à une seconde borne de la bobine L1, correspond à la masse B2 du circuit à une chute de tension de diode connue prés. Ainsi, la tension bobine correspond au potentiel à seconde borne de la bobine L1, à une chute de diode près, ce qui simplifie grandement son acquisition.

La première étape du procédé de diagnostic de ce second mode de réalisation, les moyens de commande 20 envoient un ordre de retombée fixant une tension dite de retombée aux bornes de la bobine d'actionnement 3. Les moyens de « shuntage » 21 sont dans une position ouverte et la tension de retombée est fixée par la diode « zener » Dz. La bobine est alors en mode « zener ». La tension de retombée fixée par la diode « zener » Dz est appliquée pendant toute la durée de retombée Ta. La tension électrique qui est mesurée par les moyens de mesure 25 est représentatif de la vitesse de mouvement de la partie mobile 5 de l'actionneur. Ce deuxième mode de réalisation a l'avantage de diminuer au maximum les temps d'ouverture du contacteur, tout en permettant d'avoir un signal utilisable pour le diagnostic de l'état de fonctionnement.

La deuxième étape du procédé de diagnostic de ce second mode de réalisation, consiste à déterminer une ou plusieurs valeurs spécifiques sur la courbe d'évolution de la tension aux bornes de la bobine d'actionnement 3. La ou les valeurs spécifiques peuvent, par exemple, être déterminées à partir :
- D'une ou plusieurs valeurs de tension mesurées à un temps défini, ou
- De l'intégration de valeurs de tension mesurées sur une plage temporelle définie, ou
- D'une ou plusieurs valeurs d'extremum local, extremum pouvant être un maximum ou un minimum, ou

L'avantage de l'utilisation de la tension bobine, par rapport au courant bobine, est que ce signal est indépendant de la température, ce qui minimise le biais de mesure dû à ce paramètre extérieur.

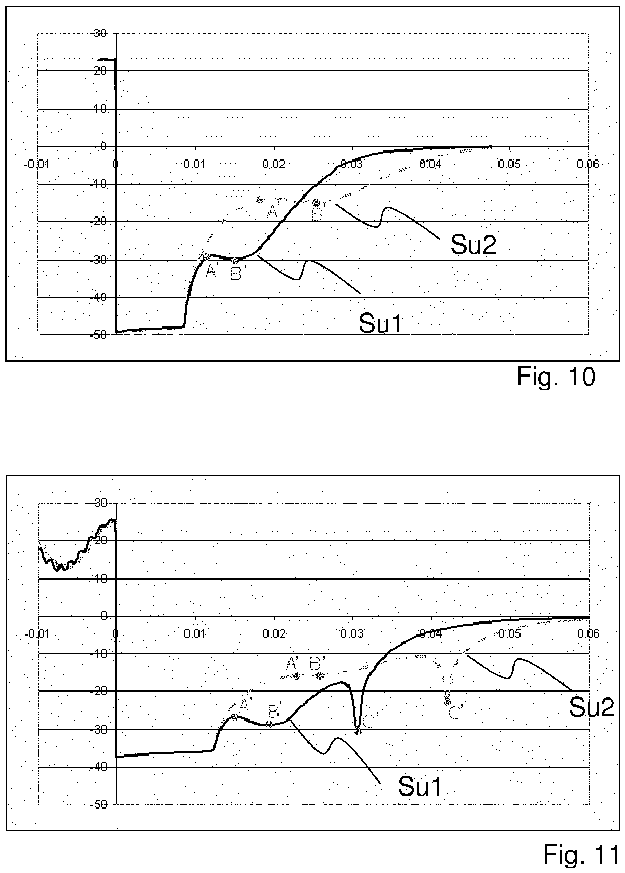

Selon un mode particulier de réalisation, la deuxième étape du procédé de diagnostic selon ce premier mode de réalisation consiste à déterminer une ou plusieurs valeurs spécifiques sur la courbe d'évolution Su de la tension électrique U de retombée aux bornes de la bobine d'actionnement 3. Comme observé sur la figure 10, plusieurs points d'extremums locaux A', B' peuvent être observés sur les courbes d'évolution Su de la tension. Notamment, un premier minimum local B' permet de définir le temps maximum séparant la commande envoyée par les moyens de commande 20 et l'apparition dudit minimum local B'. Un premier maximum local A' correspond sensiblement au début du mouvement du noyau 5 de l'actionneur. Tel que représenté sur la figure 10, une première courbe Su1 en trait plein correspond à la courbe d'évolution d'un actionneur neuf. Des seconds courbes Su2 en trait pointillé correspondent aux courbes d'évolution d'actionneurs usés.

Dans un mode particulier de réalisation de l'actionneur du contacteur, intégrant au moins un aimant, tel que représenté à la figure 9, une second minimum local C' peut être observé sur la courbe d'évolution Su de la tension (figure 11). Les premier et second minimums locaux B', C' fixent des tensions minimum aux bornes de la bobine, dans la phase de mouvement de la partie mobile 5 de l'actionneur. Ces valeurs spécifiques sont alors représentatives de la vitesse de mouvement de l'actionneur. Tel que représenté sur la figure 11, une première courbe Su1 en trait plein correspond à la courbe d'évolution de la tension d'un contacteur neuf. Des seconds courbes Su2 en trait pointillé correspondent aux courbes d'évolution de contacteurs usés.

La troisième étape du procédé de diagnostic de ce second mode de réalisation, consiste en une exploitation des valeurs spécifiques et permettre ainsi la détermination de l'état de fonctionnement.

## Revendications

1. Procédé de diagnostic d'un état de fonctionnement d'un contacteur comprenant :
- une unité de traitement (2) destinée à agir sur des moyens de commande (20) de la tension ;
- au moins une bobine d'actionnement (3) ;
- des moyens de mesure (24, 25) d'au moins une caractéristique électrique (K) de ladite au moins une bobine d'actionnement (3) ;
- au moins une diode de roue libre (D1) connectée en parallèle de ladite au moins une bobine d'actionnement (3), et des moyens de mesure (24, 25);
procédé, **caractérisé en ce qu'**il consiste à :
- envoyer un ordre de retombée consistant à fixer une tension dite de retombée aux bornes (L1, L2) de la bobine d'actionnement (3) ;
- mesurer pendant un temps de retombée (Ta), une caractéristique électrique (K) de ladite bobine d'actionnement (3) ;
- reconstituer à partir des mesures au moins une valeur spécifique;
- comparer ladite au moins une valeur spécifique à un gabarit de fonctionnement initial spécifique du contacteur ;
- diagnostiquer l'état d'usure du contacteur en fonction du positionnement ladite au moins une valeur spécifique par rapport au gabarit (G1, G2).

2. Procédé de diagnostic selon la revendication 1, **caractérisé en ce que** la tension de retombée est fixée par la diode de roue libre (D1), la bobine d'actionnement (3) étant en mode « roue libre » pendant une partie du temps de retombée (Ta).

3. Procédé de diagnostic selon la revendication 2, **caractérisé en ce que** la bobine d'actionnement (3) est en mode « roue libre » pendant tout le temps de retombée (Ta).

4. Procédé de diagnostic selon les revendications 1 ou 2, **caractérisé en ce que** des moyens de shuntage (21) commandent une diode zener (Dz) pour fixer la tension de retombée aux bornes (L1, L2) de la bobine d'actionnement (3), ladite bobine étant en mode « zener» pendant une partie du temps de retombée (Ta).

5. Procédé de diagnostic selon la revendication 4, **caractérisé en ce que** la bobine d'actionnement (3) est en mode « zener » pendant un temps intermédiaire de retombée (T1), le temps intermédiaire de retombée (T1) étant inférieur au temps total de retombée (Ta).

6. Procédé de diagnostic selon l'une des revendications précédentes, **caractérisé en ce que** ladite caractéristique électrique (K) de ladite bobine d'actionnement (3) mesurée pendant un temps total de retombée (Ta), est le courant électrique (I) circulant dans la bobine d'actionnement (3).

7. Procédé de diagnostic selon la revendication 6, **caractérisé en ce qu'**il consiste à
- déterminer au moins une valeur spécifique sur une courbe d'évolution (Si) du courant électrique (I) correspondant à un temps (Tmax) pour atteindre un premier maximum local (B) sur la courbe d'évolution (Si)
- diagnostiquer l'état de fonctionnement du contacteur en fonction du positionnement du premier maximum local (B) par rapport à un gabarit (G1,G2).

8. Procédé de diagnostic selon la revendication 7, **caractérisé en ce qu'**il consiste à déterminer un courant maximum (Imax) atteint au niveau du premier maximum local (B) sur la courbe d'évolution (Si) du courant.

9. Procédé de diagnostic selon l'une des revendications 1 à 5, **caractérisé en ce que** ladite caractéristique électrique (K) de ladite bobine d'actionnement (3) mesurée pendant un temps total de retombée (Ta), est la tension électrique (U) aux bornes la bobine d'actionnement (3).

10. Procédé de diagnostic selon la revendication 9, **caractérisé en ce qu'**il consiste à
- déterminer au moins une valeur spécifique sur une courbe d'évolution (Su) de la tension électrique (U) correspondant à un temps (Tmax) pour atteindre un premier minimum local (B') sur la courbe d'évolution (Su),
- diagnostiquer l'état de fonctionnement du contacteur en fonction du positionnement du premier minimum local (B') par rapport à un gabarit (G1,G2).

## Patentansprüche

1. Verfahren zur Diagnose eines Betriebszustands eines Schützes, das enthält:
- eine Verarbeitungseinheit (2), die dazu bestimmt ist, auf Steuereinrichtungen (20) der Spannung einzuwirken;
- mindestens eine Betätigungsspule (3);
- Messeinrichtungen (24, 25) mindestens eines elektrischen Kennwerts (K) der mindestens einen Betätigungsspule (3);
- mindestens eine Freilaufdiode (D1), die mit der mindestens einen Betätigungsspule (3) parallelgeschaltet ist, und Messeinrichtungen (24, 25);
Verfahren, das **dadurch gekennzeichnet ist, dass** es darin besteht:
- einen Abfallbefehl zu senden, der darin besteht, eine so genannte Abfallspannung an den Klemmen (L1, L2) der Betätigungsspule (3) festzulegen;
- während einer Abfallzeit (Ta) einen elektrischen Kennwert (K) der Betätigungsspule (3) zu messen;
- ausgehend von den Messwerten mindestens einen spezifischen Wert wiederherzustellen;
- den mindestens einen spezifischen Wert mit einem spezifischen Anfangsbetriebsmaß des Schützes zu vergleichen;
- den Abnutzungszustand des Schützes abhängig von der Positionierung des mindestens einen spezifischen Werts bezüglich des Maßes (G1, G2) zu diagnostizieren.

2. Diagnoseverfahren nach Anspruch 1, **dadurch gekennzeichnet, dass** die Abfallspannung durch die Freilaufdiode (D1) festgelegt wird, wobei die Betätigungsspule (3) während eines Teils der Abfallzeit (Ta) im «Freilauf»-Modus ist.

3. Diagnoseverfahren nach Anspruch 2, **dadurch gekennzeichnet, dass** die Betätigungsspule (3) während der ganzen Abfallzeit (Ta) im «Freilauf»-Modus ist.

4. Diagnoseverfahren nach den Ansprüchen 1 oder 2, **dadurch gekennzeichnet, dass** Feldschwächungseinrichtungen (21) eine Zenerdiode (Dz) steuern, um die Abfallspannung an den Klemmen (L1, L2) der Betätigungsspule (3) festzulegen, wobei die Spule während eines Teils der Abfallzeit (Ta) im «Zener»-Modus ist.

5. Diagnoseverfahren nach Anspruch 4, **dadurch gekennzeichnet, dass** die Betätigungsspule (3) während einer Zwischenabfallzeit (T1) im «Zener»-Modus ist, wobei die Zwischenabfallzeit (T1) geringer als die Gesamtabfallzeit (Ta) ist.

6. Diagnoseverfahren nach einem der vorhergehenden Ansprüche, **dadurch gekennzeichnet, dass** der während einer Gesamtabfallzeit (Ta) gemessene elektrische Kennwert (K) der Betätigungsspule (3) der elektrische Strom (I) ist, der in der Betätigungsspule (3) fließt.

7. Diagnoseverfahren nach Anspruch 6, **dadurch gekennzeichnet, dass** es darin besteht
- mindestens einen spezifischen Wert auf einer Entwicklungskurve (Si) des elektrischen Stroms (I) entsprechend einer Zeit (Tmax) zu bestimmen, um ein erstes lokales Maximum (B) auf der Entwicklungskurve (Si) zu erreichen,
- den Betriebszustand des Schützes abhängig von der Positionierung des ersten lokalen Maximums (B) bezüglich eines Maßes (G1, G2) zu diagnostizieren.

8. Diagnoseverfahren nach Anspruch 7, **dadurch gekennzeichnet, dass** es darin besteht, einen maximalen Strom (Imax) zu bestimmen, der im Bereich des ersten lokalen Maximums (B) auf der Entwicklungskurve (Si) des Stroms erreicht wird.

9. Diagnoseverfahren nach einem der Ansprüche 1 à 5, **dadurch gekennzeichnet, dass** der während einer Gesamtabfallzeit (Ta) gemessene elektrische Kennwert (K) der Betätigungsspule (3) die elektrische Spannung (U) an den Klemmen der Betätigungsspule (3) ist.

10. Diagnoseverfahren nach Anspruch 9, **dadurch gekennzeichnet, dass** es darin besteht
- mindestens einen spezifischen Wert auf einer Entwicklungskurve (Su) der elektrischen Spannung (U) zu bestimmen, der einer Zeit (Tmax) entspricht, um ein erstes lokales Minimum (B') auf der Entwicklungskurve (Su) zu erreichen,
- den Betriebszustand des Schützes abhängig von der Positionierung des ersten lokalen Minimums (B') bezüglich eines Maßes (G1, G2) zu diagnostizieren.

## Claims

1. Method for diagnosing a state of operation of a contactor comprising:
- a processing unit (2) intended to act on voltage control means (20);
- at least one actuation coil (3);
- means (24, 25) for measuring at least one electrical characteristic (K) of said at least one actuation coil (3);
- at least one freewheeling diode (D1) connected in parallel to said at least one actuation coil (3) and said measurement means (24, 25);
the method being **characterized in that** it consists in:
- sending a drop-out order consisting in setting a so-called drop-out voltage at the terminals (L1, L2) of the actuation coil (3);
- measuring, for a drop-out time (Ta), an electrical characteristic (K) of said actuation coil (3);
- reconstructing, from the measurements, at least one specific value;
- comparing said at least one specific value with a specific initial operation reference value of the contactor;
- diagnosing the state of wear of the contactor as a function of the positioning of said at least one specific value relative to the initial reference value (G1, G2).

2. Diagnostic method according to Claim 1, **characterized in that** the drop-out voltage is set by the freewheeling diode (D1), the actuation coil (3) being in "freewheeling" mode for a part of the drop-out time (Ta).

3. Diagnostic method according to Claim 2, **characterized in that** the actuation coil (3) is in "freewheeling" mode throughout the drop-out time (Ta).

4. Diagnostic method according to Claims 1 or 2, **characterized in that** shunting means (21) control a Zener diode (Dz) to set the drop-out voltage at the terminals (L1, L2) of the actuation coil (3),
said coil being in "Zener" mode for a part of the drop-out time (Ta).

5. Diagnostic method according to Claim 4, **characterized in that** the actuation coil (3) is in "Zener" mode for an intermediate drop-out time (T1), the intermediate drop-out time (T1) being less than the total drop-out time (Ta).

6. Diagnostic method according to one of the preceding claims, **characterized in that** said electrical characteristic (K) of said actuation coil (3) measured during a total drop-out time (Ta), is the electrical current (I) flowing in the actuation coil (3).

7. Diagnostic method according to Claim 6, **characterized in that** it consists in:
- determining at least one specific value on a trend curve (Si) of the electrical current (I) corresponding to a time (Tmax) to reach a first local maximum (B) on the trend curve (Si)
- diagnosing the state of operating of the contactor as a function of the positioning of the first local maximum (B) relative to a reference value (G1, G2).

8. Diagnostic method according to Claim 7, **characterized in that** it consists in determining a maximum current (Imax) reached at the level of the first local maximum (B) on the trend curve (Si) of the current.

9. Diagnostic method according to one of Claims 1 to 5, **characterized in that** said electrical characteristic (K) of said actuation coil (3) measured during a total drop-out time (Ta), is the electrical voltage (U) at the terminals of the actuation coil (3).

10. Diagnostic method according to Claim 9, **characterized in that** it consists in:
- determining at least one specific value on a trend curve (Su) of the electrical voltage (U) corresponding to a time (Tmax) to reach a first local minimum (B') on the trend curve (Su)
- diagnosing the state of operation of the contactor as a function of the positioning of the first local minimum (B') relative to a reference value (G1, G2).
